# EUROPEAN PATENT SPECIFICATION

(11) **EP 1 523 776 B1**
(45) Date of publication and mention of the grant of the patent: **15.05.2019**
(21) Application number: 03765562.8
(22) Date of filing: 15.07.2003
(51) Int. Cl.: H01L 33/00, H01L 33/38, H01L 33/40

(54) **LIGHT EMITTING DIODE INCLUDING BARRIER LAYERS AND MANUFACTURING METHODS THEREFOR**
LEUCHTDIODE MIT BARRIERESCHICHTEN UND HERSTELLUNGSVEFAHREN
DIODE ELECTROLUMINESCENTE COMPRENANT DES COUCHES BARRIERES ET PROCEDE DE FABRICATION CORRESPONDANT

(30) Priority: 22.07.2002 US 200244; 28.02.2003 US 450960 P
(43) Date of publication of application: 20.04.2005
(60) Divisional application: 10185865.2
(73) Proprietor: Cree, Inc., Durham, NC 27703 (US)
(72) Inventor: SLATER, JR., David, B., Raleigh, NC 27617 (US); WILLIAMS, Bradley, E., Cary, NC 27511 (US); ANDREWS, Peter, S., Durham, NC 27712 (US); EDMOND, John, A., Cary, NC 27511 (US); ALLEN, Scott, T., Apex, NC 27502 (US); BHARATHAN, Jayesh, Santa Barbara, CA 93111-1839 (US)
(74) Representative: Boult Wade Tennant LLP
(86) International application number: PCT/US2003/021909
(87) International publication number: WO 2004/010509

(56) References cited:
- WO-A-01/47039
- WO-A-02/075819
- WO-A-02/101841
- WO-A-03/010817
- US-A- 3 894 919
- US-A- 4 238 764
- US-A- 4 441 187
- PATENT ABSTRACTS OF JAPAN vol. 1999, no. 13, 30 November 1999 (1999-11-30) -& JP 11 220168 A (TOYODA GOSEI CO LTD), 10 August 1999 (1999-08-10)
- PATENT ABSTRACTS OF JAPAN vol. 2000, no. 03, 30 March 2000 (2000-03-30) -& JP 11 340514 A (NICHIA CHEM IND LTD), 10 December 1999 (1999-12-10)
- PATENT ABSTRACTS OF JAPAN vol. 2002, no. 02, 2 April 2002 (2002-04-02) -& JP 2001 291899 A (SANKEN ELECTRIC CO), 19 October 2001 (2001-10-19)
- PATENT ABSTRACTS OF JAPAN vol. 1999, no. 09, 30 July 1999 (1999-07-30) -& JP 11 121803 A (HITACHI CABLE LTD), 30 April 1999 (1999-04-30)

## Description

### Field of the Invention

This invention relates to light emitting devices, such as light emitting diodes (LEDs) and manufacturing methods therefor.

### Background of the Invention

Light emitting diodes are widely used in consumer and commercial applications. As is well known to those having skill in the art, a light emitting diode generally includes a diode region on a microelectronic substrate. The microelectronic substrate may comprise, for example, gallium arsenide, gallium phosphide, alloys thereof, silicon carbide and/or sapphire. Continued developments in LEDs have resulted in highly efficient and mechanically robust light sources that can cover the visible spectrum and beyond. These attributes, coupled with the potentially long service life of solid state devices, may enable a variety of new display applications, and may place LEDs in a position to compete with the well entrenched incandescent and fluorescent lamps.

Gallium Nitride (GaN)-based LEDs typically comprise an insulating or semiconducting substrate such as silicon carbide (SiC) or sapphire on which a plurality of GaN-based epitaxial layers are deposited. The epitaxial layers comprise an active or diode region having a p-n junction which emits light when energized.

LEDs may be mounted substrate side down onto a submount, also called a package or lead frame (hereinafter referred to as a "submount"). In contrast, flip-chip mounting of light emitting diodes involves mounting the LED onto the submount with the substrate side facing up (i.e. away from the submount). Light may be extracted and emitted through the substrate. Flip chip mounting may be an especially desirable technique for mounting SiC-based LEDs. In particular, since SiC has a higher index of refraction than GaN, light generated in the active or diode region generally does not totally internally reflect (i.e. reflect back into the GaN-based layers) at the GaN/Sic interface. Flip chip mounting of SiC-based LEDs also can improve the effect of certain substrate-shaping techniques known in the art. Flip chip packaging of SiC LEDs may have other benefits, such as improved heat dissipation, which may be desirable depending on the particular application for the LED.

Because of the high index of refraction of SiC, light passing through a SiC substrate tends to be totally internally reflected into the substrate at the surface of the substrate unless the light strikes the surface at a fairly low angle of incidence (i.e. fairly close to normal). The critical angle for total internal reflection generally depends on the material with which SiC forms an interface. It is possible to increase the light output from a SiC-based LED by shaping the SiC substrate in a manner that limits total internal reflection by causing more rays to strike the surface of the SiC at low angles of incidence. A number of such shaping techniques and resulting devices are taught in U.S. Patent Application Serial No. 10/057,821 to Slater et al, corresponding to U.S. Publication No. US 2002/0123164 A1, published September 5, 2002, entitled *Light*

### Emitting Diodes Including Modifications for Light Extraction and Manufacturing Methods Therefor.

One potential problem with flip-chip mounting is that when an LED is mounted on a submount using conventional techniques, a conductive die attach material such as silver epoxy is deposited on the LED and/or on the package, and the LED and the submount are pressed together. This can cause the viscous conductive die attach material to squeeze out and make contact with the N-type substrate and/or layers in the device, thereby forming a Schottky diode connection that can short-circuit the p-n junction in the active region.

Metal-metal bonds formed by soldering, thermosonic scrubbing and/or thermocompression bonding are alternative attach techniques. However, tin (Sn) is a component of most types of solder, and migration of Sn from the bonded surface into the device can cause unwanted degradation of the device. Such migration can interfere with metal-semiconductor interfaces such as ohmic contacts and/or the function of metal-metal interfaces such as reflective interfaces that serve as mirrors.

WO 01/47039 A1 discloses an LED comprising an ohmic contact layer, a silver reflector layer on the ohmic contact layer, and a dielectric passivation layer on the reflector layer which extends on the reflector layer sidewall and on the ohmic contact layer sidewall. JP H11-121803 A, JP 2001-291899 A and US 4,238,764 disclose an LED comprising an ohmic contact layer, a reflector layer on the ohmic contact layer, and a metal conductive layer on the reflector layer which extends on the reflector layer sidewall and on the ohmic contact layer sidewall.

### Summary of the Invention

In accordance with the present invention, there is provided a light emitting device as claimed in claim 1; and a corresponding method as claimed in claim 13.

### Brief Description of the Drawings

Figures 1-10 are cross-sectional views of light emitting diodes according to some examples not forming part of the present invention during intermediate fabrication steps.
Figures 11A-12D graphically illustrate test results for light emitting diodes according to some examples not forming part of the present invention.
Figures 13-15 are cross-sectional views of light emitting diodes according to some embodiments of the present invention.
Figures 16 and 17 are SEM images of light emitting diodes according to some embodiments of the present invention.

### Detailed Description of Preferred Embodiments

The present invention now will be described more fully hereinafter with reference to the accompanying figures, in which embodiments of the present invention are shown. This invention may, however, be embodied in many alternate forms and should not be construed as limited to the embodiments set forth herein.

Accordingly, while the present invention is susceptible to various modifications and alternative forms, specific embodiments thereof are shown by way of example in the drawings and will herein be described in detail. It should be understood, however, that there is no intent to limit the present invention to the particular forms disclosed, but that the scope of the present invention is defined by the claims. Like numbers refer to like elements throughout the description of the figures. In the figures, the dimensions of layers and regions may be exaggerated for clarity. It will also be understood that when an element, such as a layer, region or substrate, is referred to as being "on" another element, it can be directly on the other element or intervening elements may also be present. In contrast, when an element, such as a layer, region or substrate, is referred to as being "directly on" another element, there are no intervening elements present. Moreover, each embodiment described and illustrated herein includes its complementary conductivity type embodiment as well.

Embodiments of the present invention now will be described generally with reference to gallium nitride-based light emitting diodes on silicon carbide-based substrates. However, it will be understood by those having skill in the art that many embodiments of the present invention may employ any combination of a substrate that is non-absorbing or transparent to the emitted light and an index matched light emitting diode epitaxial layer. In some embodiments of the present invention, the refractive index of the substrate is greater than that of the diode. Accordingly, combinations can include an AlGaInP diode on a GaP substrate; an InGaAs diode on a GaAs substrate; an AlGaAs diode on a GaAs substrate; an SiC diode on an SiC substrate, an SiC diode on a sapphire (Al₂O₃) substrate; and/or a nitride-based diode on a gallium nitride, silicon carbide, aluminum nitride, zinc oxide and/or other substrate. Finally, it will be understood that although embodiments of the present invention are described herein with respect to light emitting diodes having an epitaxial region that includes therein a light emitting diode region, other embodiments of the present invention may be used with other semiconductor light emitting devices such as lasers, wherein an epitaxial region includes therein a light emitting region such as a laser diode region.

The present invention provides LED devices that can be flip chip mounted using soldering and/or thermosonic bonding, and that include a metal conductive barrier layer that can reduce or eliminate unwanted degradation of the metal and/or semiconductor layers of the LED. Other embodiments of the present invention can provide both a passivation layer and the metal conductive barrier layer. Yet other embodiments of the present invention provide methods of fabricating these LED devices. Solder barrier layers according to some embodiments of the present invention can provide means for reducing migration of tin and/or other undesired materials into the LED.

In a conventional sapphire-based approach, an LED, also referred to as a chip or die, is attached to a submount with a clear epoxy. In the case of LEDs having conductive SiC substrates, a conducting silver filled epoxy is typically used to attach the LED and the submount to one another. Conventional nitride-based LEDs on SiC or sapphire substrates generally are packaged with the epitaxial side up and with the substrate bonded to the submount.

Some conventional SiC-based LEDs have an n-type conductive substrate and an epitaxial region on the substrate that includes one or more n-type epitaxial layers and one or more p-type epitaxial layers to define a diode surface. As discussed in U.S. Patent Application Serial No. 10/057,821, corresponding to U.S. Publication No. US 2002/0123164 A1, referenced above, it may be beneficial to form a reflector layer over the thin transparent ohmic contact to improve light extrication form the device. The reflective layer can serve to spread electric current uniformly across the thin contact, and also to reflect light back into the substrate, away from the submount.

Unfortunately, if Sn and/or other contaminants from a solder or thermosomic/thermocompression bond migrates from the bonding surface to the reflector layer, the reflector layer may become less reflective. Moreover, if the contaminants migrate beyond the reflector to the transparent ohmic contact, the transparent ohmic contact may develop a higher specific contact resistivity, thus increasing the forward voltage (V_{F}) of the device. Both of these results may be characterized as degradation of the device.

A reflective layer comprises Ag, and the thin transparent ohmic layer can comprise Pt, Pd, Ni, Ti, Au or a combination of these elements. Unfortunately, Sn readily forms alloys with Ag, Pt, Au and with numerous other metals used in semiconductor manufacturing.

A first portion of series of conductive layers (referred to herein as a "multilayer conductive stack") that is formed on the p-type surface of an LED according to the present invention comprises an ohmic contact layer, a reflector layer, and a metal barrier layer. In some embodiments, the barrier layer comprises a thin layer of titanium, titanium/tungsten (TiW) and/or titanium nitride/tungsten and a second layer comprising nickel on the first layer. The metal barrier layer extends directly onto the reflector layer, the sidewalls of the reflector layer and the sidewalls of the ohmic contact layer and may include an alternating stack of a first metal barrier sublayer and a second metal barrier sublayer.

In some embodiments of the present invention, this portion of the multilayer conductive stack and the top of the device are passivated with a passivation layer, such as an insulating layer to which a solder or eutectic die attach material will not wet. The passivation layer can be formed by conventional spin-on or deposition techniques such as Chemical Vapor Deposition (CVD) and/or reactive sputtering, and it can comprise an insulating oxide and/or nitride such as silicon dioxide and/or silicon nitride.

In some embodiments of the present invention, an opening in the passivation layer is then formed with lateral dimensions (i.e. surface area) that are smaller than the lateral dimensions of the barrier layer such that only a portion of the surface of the barrier layer is exposed. Such an opening can be produced using conventional photolithography and etching techniques. An optional adhesion layer that may comprise Ti, is formed in the opening and a thick bonding layer that may comprise Au, Sn and/or AuSn also is formed. In other embodiments, an optional solder wetting layer is provided between the adhesion layer and the bonding layer. The solder wetting layer can provide an enhanced mechanical connection between the solder and the LED, which can increase the shear strength of the connection.

In some embodiments of the present invention, the bonding layer can serve to protect the barrier layer if mechanical stress is to be applied to the multilayer conductive stack by a probe tip during electrical tests. Furthermore, in other embodiments of the present invention, the Au in the bonding layer can serve to protect the barrier layer from oxidation. In yet other embodiments of the present invention, AuSn may be employed in the bonding layer as a eutectic die attach material that may be used to bond an LED and a submount to one another via thermosonic or thermocompression bonding as an alternative to solder bonding.

Multilayer conductive stacks according to some embodiments of the present invention can be well suited for solid state devices in that some embodiments of the present invention can provide a stack that is considerably thinner than may be achieved if a solder barrier is formed using Ni or NiV. In some embodiments of the present invention, a barrier layer comprising W, TiW and/or TiNW and/or W and Ni layers can be less than half of the thickness that may be used if only Ni were used as the barrier layer. This may be advantageous when considering the generally small lateral dimensions of solid state devices and when considering the potential difficulty associated with the use of conventional fabrication techniques if large topographical dimensions are present. The barrier layer also can provide a desired vertical barrier against Sn and/or other undesired migration.

Passivation layers according to some embodiments of the invention can cover the entire epitaxial surface of the LED except for a reduced area opening that exposes the barrier layer, and can provide a dam to reduce or prevent Sn and/or other undesired migration into the reflective mirror layer or the ohmic contact, or down the edges of the metal stack. In the case of an LED having a conducting substrate, passivation layers according to some embodiments of the invention also can serve to keep the die attach material from contacting the substrate which could produce undesired effects such as formation of a parasitic Schottky diode.

Large area LEDs operating at high power levels may use packaging that has low thermal resistance to reduce or prevent degradation of the device performance. Epoxy based die attach materials may have high thermal resistance in comparison to metal die attach materials. In a flip-chip configuration, the p-n junction region of an LED is mounted extremely close to the heat sinking package, which can bypass the thermal resistance of the substrate. This may be used for large-area SiC-based LEDs in some embodiments of the present invention, despite the low thermal resistance of SiC. The metal-metal bond provided by some embodiments of the present invention also may be used in LEDs having sapphire substrates, due to the high thermal resistance of sapphire. Consequently, some embodiments of the present invention may be used for large area LEDs, which may benefit from employing a junction down (flip-chip) metal-metal die attach configuration. Other embodiments of the present invention may be used with small-area LEDs.

Some embodiments of the present invention also may increase the permissible temperature range that the device can withstand during subsequent packaging, assembly and re-work/repair steps. Metal-metal bonds can be engineered for subsequent thermal cycles, for example, where the LED is mounted to a printed circuit board. If the LED die is attached to its submount with a AuSn thermosonic or thermocompression bond at 300°C or by SnAg solder at 230°C, subsequent processing cycles using SnPb solder at 200°C may not cause mechanical failure by reflowing the die attach bond. That is, subsequent processing at elevated temperatures may not cause the LED die to detach from the submount. In contrast, LEDs using epoxy based die attach methods may not withstand high thermal cycles. Moreover, clear epoxy can become discolored during thermal processing, resulting in unwanted light attenuation.

Some embodiments of the present invention may also increase the shear strength of resulting bonds between the LED and the submount. Inclusion of a solder barrier layer which reduces or prevents tin and/or other unwanted materials from reaching the epitaxial layers of the device can preserve the adhesive strength of the metal-semiconductor interface and can result in a more robust, mechanically stable device. In particular, it has been found that embodiments that include a nickel solder wetting layer beneath a gold bonding layer may exhibit superior shear strength. The shear strength may also be maintained through thermal cycles during subsequent packaging, assembly and re-work/repair steps.

In addition, some embodiments of the present invention may improve the thermal conductivity of the resulting device. This effect may be particularly apparent in so-called "power" or large area LEDs which may carry a substantially higher current than conventional LEDs. In such LEDs, some embodiments of the present invention can prevent or reduce "voiding" within the metallic layers. Voiding refers to the formation of physical voids or spaces within a metallic region. Some embodiments of the present invention may serve to maintain a tight grain structure within such metallic layers, thereby allowing the device to maintain a high thermal conductivity despite operation at high power levels with correspondingly high junction temperatures. Improved thermal conductivity also may help reduce degradation of encapsulant materials in which LEDs, and in particular power LEDs, are packaged. Such encapsulants are typically sensitive to heat and may yellow and become less transparent after expose to high temperatures for extended periods of time. By improving the thermal conductivity of the LED mount interface, less heat may be dissipated through the encapsulant, which can result in reduced degradation.

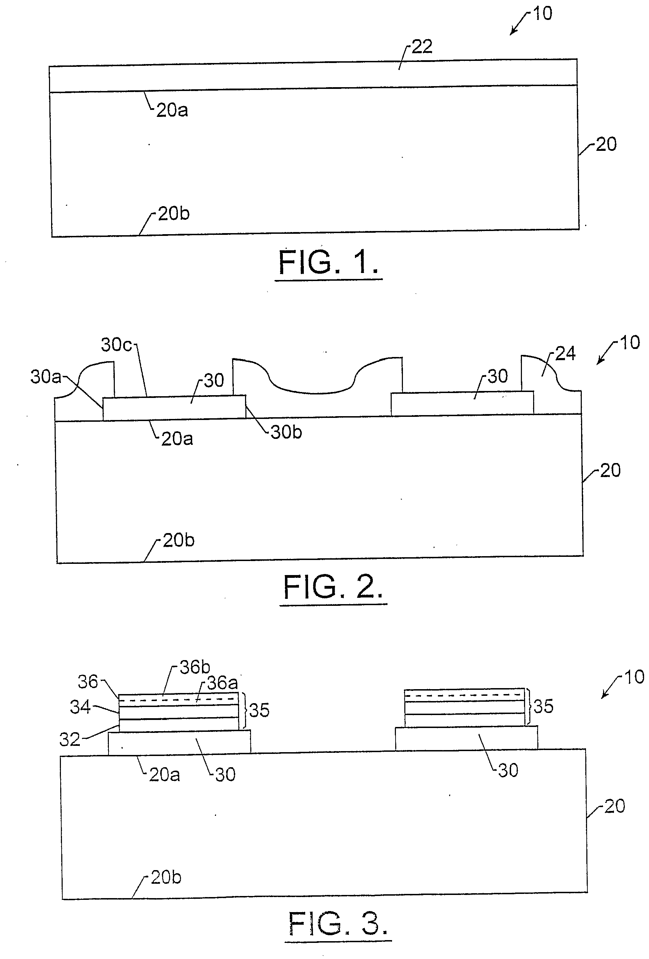

Figure 1 illustrates an LED device precursor **10** according to some examples not forming part of the present invention, comprising a substrate **20** having first and second opposing faces **20a** and **20b,** respectively, and an epitaxial region **22** formed on the first face **20a** of the substrate **20.** Substrate **20** may comprise silicon carbide, sapphire, aluminum nitride, gallium nitride or any other suitable conductive or non-conductive substrate material. The substrate **20** may comprise conductively doped SiC. The substrate **20** may be transparent to optical radiation in a predetermined wavelength range. The epitaxial region **22** may comprise a conductive buffer layer and a plurality of Group III-nitride epitaxial layers, at least some of which provide a diode region. The dimensions of the substrate, epitaxial layers and metal layers shown in Figures 1-10 are not drawn to scale but are exaggerated for illustrative purposes. A thin SiO₂ and/or other layer (not shown) may optionally be formed, for example, by Plasma Enhanced Chemical Vapor Deposition (PECVD) on the surface of the epitaxial region **22** to protect it during subsequent processing and cleaning steps.

Subsequent to deposition of the epitaxial region **22,** the epitaxial region **22** is patterned as shown in Figure 2 to form a plurality of mesas **30** each having sidewalls **30a, 30b.** Although not illustrated in Figure 2, the mesas **30** may extend into the substrate **20.** Moreover, the mesas **30** may be formed by selective epitaxial growth through openings in a mask, rather than blanket epitaxial growth and etching.

Still referring to Figure 2, a layer of photoresist **24** and/ or other material is formed on the surface of the precursor **10** and patterned to expose the surface of the mesas **30,** thereby defining a first reduced area **30c** on the surface of the mesas **30.** If an optional SiO₂ layer is present, it may be etched through the openings in the photoresist **24** to expose the first reduced area **30c** on the epitaxial surface layer of the epitaxial region **22** in the mesa **30.**

A multilayer conductive stack **35** is then formed on the first reduced areas 30c of the mesas **30** using, for example, conventional lift-off techniques. As shown in Figure 3, the multilayer conductive stack **35** includes an ohmic layer **32,** a reflector layer **34** and a barrier layer **36.** The ohmic layer **32** may comprise platinum, but it may also comprise palladium, nickel/gold, nickel oxide/gold, nickel oxide/platinum, titanium and/or titanium/gold. Other examples of ohmic layers are described in the above-referenced U.S. Publication No. US 2002/0123164 A1. If the ohmic layer **32** comprises Pt, it may be about 2.5 nm (25Å) thick. The reflector layer **34** comprises Ag. The reflector layer **34** may be about 100 nm (1,000Å) thick. Other examples of reflector layers are described in the above-referenced Application Serial No. 10/057,821, corresponding to U.S. Publication No. US 2002/0123164 A1.

The barrier layer **36** can be a solder barrier layer to prevent solder metals such as tin from reacting with the reflector layer **34** and/or ohmic layer **32.** The barrier layer **36** may comprise W, TiW and/or TiN/W and may be between about 5 nm (50Å) and about 5,000 nm (50,000Å) thick, it may also be about 500 nm (5,000Å) thick. The barrier layer **36** may comprise TiW having a composition of about 5% Ti and about 95% W.

Barrier layer **36** that comprise tungsten or titanium/tungsten and that are between about 50 nm (500Å) thick to about 300 nm (3,000Å) thick, may be used when a solder bonding operation (described below) is performed at a reflow temperature of less than about 210°C. For example, when eutectic gold/lead/tin solders are used at reflow temperatures of about 190°C to about 210°C, a barrier layer comprising between about nm (500Å) and about 300 nm (3,000Å) of titanium/tungsten may be used. Higher reflow temperatures may be used to accommodate other solders, such as solders comprising tin, silver and antimony, that have a reflow temperature of about 220°C to about 260°C. One example of these solders is a Kester brand R276AC silver-tin solder paste that is about 96.5% tin and about 3.5% silver. Accordingly, the barrier layer **36** may comprise a first layer of tungsten or titanium/tungsten **36a** that is about 500 nm (5,000Å) thick, and a second layer **36b** comprising nickel that is about 200 nm (2,000Å) thick, on the first layer, **36a.** It has been found that some of these examples can withstand temperatures of between about 325° and about 350°C, for about five minutes, without substantially increasing the forward voltage (V_{F}) or reduce the light output of the LED. Thus, a multilayer barrier layer **36** comprising a layer of tungsten or titanium/tungsten **36a** and a layer of nickel **36b** may be used with solders that have a reflow temperature of more than about 200°C. These multilayer barrier layers may also be used with solders that have a reflow temperature of more than about 250°C. Tungsten, silver and platinum are deposited, for example, using an e-beam technique. TiW may be deposited using an e-beam technique, but Ti and W may also be simultaneously sputter deposited. In addition, the TiW may be sputter deposited in the presence of nitrogen to form a TiN/TiW layer that also forms a barrier to Sn diffusion. The barrier layer **36** may consist essentially of nickel or NiV. The barrier layer **36** may also comprise a 250 nm (2,500Å) nickel solder barrier covered completely with a layer of gold between about 50 nm (500Å) and 1,000 nm (10,000Å) thick. The gold layer can prevent the nickel layer from oxidizing. However, the use of a nickel barrier layer may result in unacceptably high degradation of optical and electrical performance at elevated temperature and current levels due to tin migration. Moreover, thicker films of nickel may be difficult to use since the film stress may be high. This may create concern with respect to delamination of the nickel from the adjacent reflective and/or ohmic layers. Moreover, the presence of Au at the edges of the barrier layer may create a path for Sn to migrate down and around the edges of the barrier.

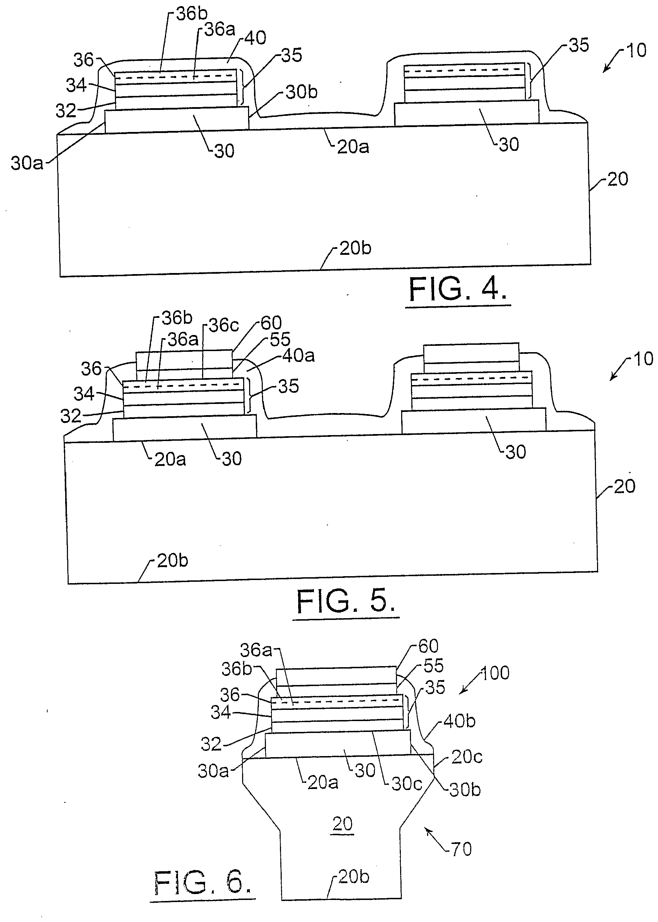

Referring now to Figure 4, a passivation layer **40** is deposited or otherwise formed on the first (or epitaxial-side) surface **20a** of device precursor **10.** Passivation layer **40** may comprise SiO₂ and/or SiN (which may be deposited in stoichiometric or non-stoichiometric amounts) and may be deposited by conventional techniques such as PECVD and/or reactive sputtering. The passivation layer **40** may be about 150 nm (1,500Å) thick. As also shown in Figure 4, this blanket deposition also forms the passivation layer on the sidewalls of the mesas **30** and the multilayer conductive stack **35,** and on the exposed surface of the barrier layer **36.**

Referring now to Figure 5, the passivation layer **40** is patterned with an etch mask (such as a photoresist) to provide a first patterned passivation layer **40a** and to selectively reveal a second reduced area portion **36c** of the surface of barrier layer **36.** A lift off technique may be used to expose the second reduced area portion **36c** of the surface of the barrier layer **36.** Selective deposition of the passivation layer **40a** may also be used so that a separate patterning step need not be used.

Still referring to Figure 5, an optional adhesion layer **55** comprising, for example, Ti is then deposited on the second reduced area **36c** of the barrier layer **36** and a bonding layer **60** is deposited on the adhesion layer **55.** These depositions may be performed using the patterned passivation layer **40a** as a mask and/or using lift-off techniques. The adhesion layer **55** may be about 100 nm (1,000Å) thick. The bonding layer **60** may comprise Au, Sn and/or AuSn and may be about 100 nm (1,000Å) thick. The bonding layer **60** may be up to about 1µm thick (if Au) or about 1.7µm thick (if AuSn). However use of a layer of Au that is thicker than about 100 nm (1,000Å) may lead to inconsistent solder reflow processing or Au embrittlement of the solder attachment, which may result in low shear strength. As shown, the patterned passivation layer **40a** may also be on the sidewalls of the adhesion layer **55** and the bonding layer. The patterned passivation layer **40a** may not extend on the sidewalls of the adhesion layer **55** and the bonding layer **60.** In these examples, the passivation layer may extend on the sidewalls of the conductive stack **35.** The bonding layer **60** may extend away from the multilayer conductive stack **35,** to beyond the patterned passivation layer **40a.** The bonding layer **60** may also not extend to beyond the outer surface of the patterned passivation layer **40a.**

For devices formed on conductive substrates, ohmic contacts and a wire bond pad (not shown) are formed on the second substrate face **20b** opposite the epitaxial region to form a vertically-conductive device. Many such examples are described in Application Serial No. 10/057,821, corresponding to U.S. Publication No. US 2002/0123164 A1. For devices formed on non-conductive substrates, ohmic contacts and metal bonding layers (not shown) may be formed on an n-type epitaxial region of the device to form a horizontally-conductive device. Many such examples also are shown in Application Serial No. 10/057,821, corresponding to U.S. Publication No. US 2002/0123164 A1.

Referring now to Figure 6, the precursor **10** is diced into individual light emitting diodes **100.** Figure 6 also shows that LEDs **100** may be sawed such that they have a beveled sidewall configuration **70** to increase light extraction. Many other examples of substrate shaping are described in Application Serial No. 10/057,821, corresponding to U.S. Publication No. US 2002/0123164 A1.

Accordingly, Figure 6 illustrates light emitting diodes **100** according to some examples not forming part of the present invention that include a substrate **20,** an epitaxial region (referred to previously as a mesa) **30** on the substrate **20** that includes therein a diode region, a multilayer conductive stack **35** on the epitaxial region **30** opposite the substrate **20,** and a passivation layer **40b** that extends at least partially on the multilayer conductive stack **35** opposite the epitaxial region **30,** to define a reduced area bonding region **36c** on the multilayer conductive stack **35** opposite the epitaxial region **30.** The passivation layer **40b** may also extend across the multilayer conductive stack **35,** across the epitaxial region **30,** and onto the first substrate face **20a.** As also shown in Figure 6, the multilayer conductive stack **35** and the epitaxial region **30** may both include sidewalls, and the passivation layer **40b** extends on the sidewalls of the multilayer conductive stack **35** and of the epitaxial region **30.** As also shown in Figure 6, a bonding layer **60** is provided on the bonding region **36c.** The bonding layer **60** also includes a bonding layer sidewall, and the passivation layer **40b** may or may not extend onto the bonding layer sidewall. Finally, an adhesion layer **55** may be provided between the multilayer conductive stack **35** and the bonding layer **60,** and the passivation layer **40b** also may or may not extend onto the sidewall of the adhesion layer **55** and/or the bonding layer **60.**

Still referring to Figure 6, the substrate **20** includes a first face **20a** adjacent the epitaxial region **30** and a second face **20b** opposite the epitaxial region. As illustrated in Figure 6, the bonding layer **60** has smaller surface area than the multilayer conductive stack **35** and the multilayer conductive stack **35** has smaller surface area than the epitaxial region **30.** The epitaxial region **30** has smaller surface area than the first face **20a.** The second face **20b** also has smaller surface area than the first face **20a.**

Figure 6 also illustrates light emitting diodes that include a substrate **20** having first and second opposing faces **20a** and **20b,** respectively, the second face **20b** having smaller surface area than the first face. An epitaxial region **30** is on the first face **20a,** and includes therein a diode region. An ohmic layer **32** is on the epitaxial region **30** opposite the substrate **20.** A reflector layer **34** is on the ohmic layer **32** opposite the epitaxial region **30.** A barrier layer **36** is on the reflector layer **34** opposite the ohmic layer **32.** An adhesion layer **55** is on the barrier layer **36** opposite the reflector layer **34.** Finally, a bonding layer **60** is on the adhesion layer **55** opposite the barrier layer **36.**

As also shown in Figure 6, the barrier layer **36** comprises tungsten, titanium/tungsten and/or titanium nitride/tungsten. The tin barrier layer **36** may comprise a first layer **36a** comprising tungsten and a second layer **36b** comprising nickel on the first layer **36a** comprising tungsten.

As also shown in Figure 6, the epitaxial region **30** has smaller surface area than the first face **20a.** The barrier layer **36,** the reflector layer **34** and the ohmic layer **32** have same surface area, that surface area being less than that of the epitaxial region **30.** The adhesion layer **55** and the bonding layer **60** have same surface area, that surface area being smaller than that of the barrier layer **36,** the reflector layer **34** and the ohmic layer **32.**

Finally, as also shown in Figure 6, the epitaxial region **30,** the ohmic layer **32,** the reflector layer **34,** the barrier layer **36,** the adhesion layer **55** and the bonding layer **60** each include a sidewall and the light emitting diode **100** further includes a passivation layer **40b** on the sidewalls of the epitaxial region **30,** the ohmic layer **32,** the reflector layer **34** and the barrier layer **36.** The passivation layer also may or may not extend onto the sidewalls of the adhesion layer **55** and/or the bonding layer **60.** The passivation layer **40b** also may extend on the first face **20a** of the substrate **20.**

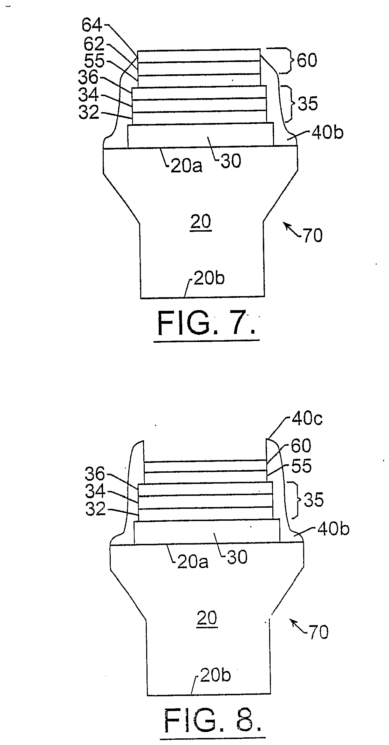

Figure 7 illustrates other examples not forming part of the present invention in which the bonding layer **60** comprises a solder wetting layer **62** and a wetting passivation layer **64.** The solder wetting layer **62** may comprise nickel and may be about 200 nm (2,000Å) thick. The wetting passivation layer **64** may comprise Au and may be about 50 nm (500Å) thick. Use of the nickel solder wetting layer **62** can provide an enhanced mechanical bond to the solder, which can increase the shear strength of the connection and can reduce the possibility of mechanical failure. Figure 8 illustrates other examples not forming part of the present invention in which the bonding layer **60** and optional adhesion layer **55** do not extend beyond the outer edge **40c** of the passivation layer **40b.** This configuration may be used when solder bonding is used to mount the LED to a lead frame.

Figures 1-8 also illustrate methods of fabricating a plurality of light emitting diodes according to some examples not forming part of the present invention. These methods comprise epitaxially forming a plurality of spaced apart mesa regions **30** on a substrate **20**, the mesa regions including therein a diode region (Figure 2). A first reduced area region **30c** is defined on the mesa regions (Figure 2). A multilayer conductive stack **35** that includes a barrier layer, is formed on the first reduced area regions **30c** of the mesa regions **30** (Figure 3). A passivation layer **40a** is formed on the substrate **20** between the mesa regions **30**, on exposed portions of the mesa regions and on exposed portions of the multilayer stack **35**, the passivation layer **40a** defining a second reduced area region **36c** on the multilayer conductive stack **35** (Figures 4 and 5). A bonding layer **60** then is formed on the second reduced area regions **36c** of the multilayer conductive stacks **35** (Figure 5). The substrate **20** is diced between the mesas **30** to produce the plurality of light emitting diodes **100** (Figure 6).

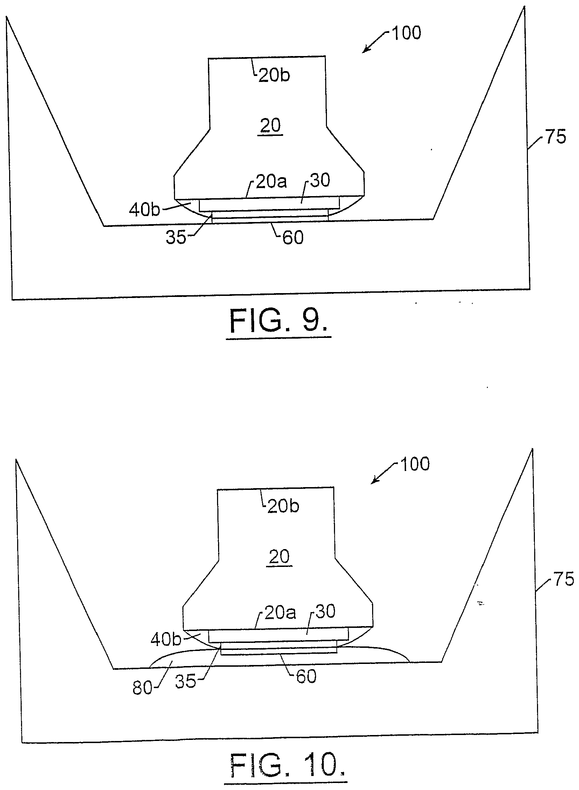

Referring now to Figures 9 and 10, once the LED **100** has been diced, the LED and a conductive submount **75** are attached to one another as illustrated in Figures 9 and 10. Figure 9 illustrates examples not forming part of the present invention in which the LED **100** is mounted in a "flip-chip" configuration with the epitaxial side down, via thermosonic and/or thermocompression bonding. That is, instead of using an epoxy or a solder to form a mechanical connection or bond between the LED **100** and the submount **75**, the bonding layer **60** of LED **100** is thermosonically or thermocompressively bonded directly to the submount **75** as described, for example, in United States Provisional Application Serial No. 60/307,234 and U.S. Publication No. US 2003/0042507 A1.

In some embodiments of thermosonic or thermocompression bonding according to some embodiments of the present invention, the LED chip **100** is placed into mechanical contact with the submount and subjected to mechanical and/or sonic stimulation at a temperature greater than the eutectic temperature of the bonding metal. The bonding metal thus forms a bond with the metallic submount, which provides an electromechanical connection between the LED and the submount. In embodiments of the present invention in which the bonding layer **60** has an Au/Sn relative composition of about 80%/20%, the temperature used for thermosonic bonding may be approximately 300 °C.

The presence of the barrier layer **36** and/or the passivation layer **40b** can reduce or prevent unwanted interaction between metals in the bonding layer **60** with the reflective layer **34** and/or the ohmic layer **32.** The barrier layer **36** and/or the passivation layer **40** may also serve to retard or inhibit unwanted migration of metal along the edge of the metal stack **35.**

In other examples not forming part of the present invention, the LED **100** may be mounted on the submount **75** using a metal solder **80** such as SnAg, SnPb and/or other solders as illustrated in Figure 10. The passivation layer **40b** can reduce or prevent Sn from solder **80** from migrating to (and thereby potentially degrading) the reflective layer **34** and/or ohmic layer **32.** The passivation layer **40b** also can reduce or prevent conductive solder **80** from contacting the substrate **20** and mesa sidewalls, which may otherwise result in the formation of unwanted parasitic Schottky contacts to n-type regions of the device **100.** Other bonding techniques that may be used, according to other embodiments of the present invention, are disclosed in the above-cited Provisional Application Serial No. 60/307,311 and U.S. Publication No. 2003/0045015 A1.

### Test Results

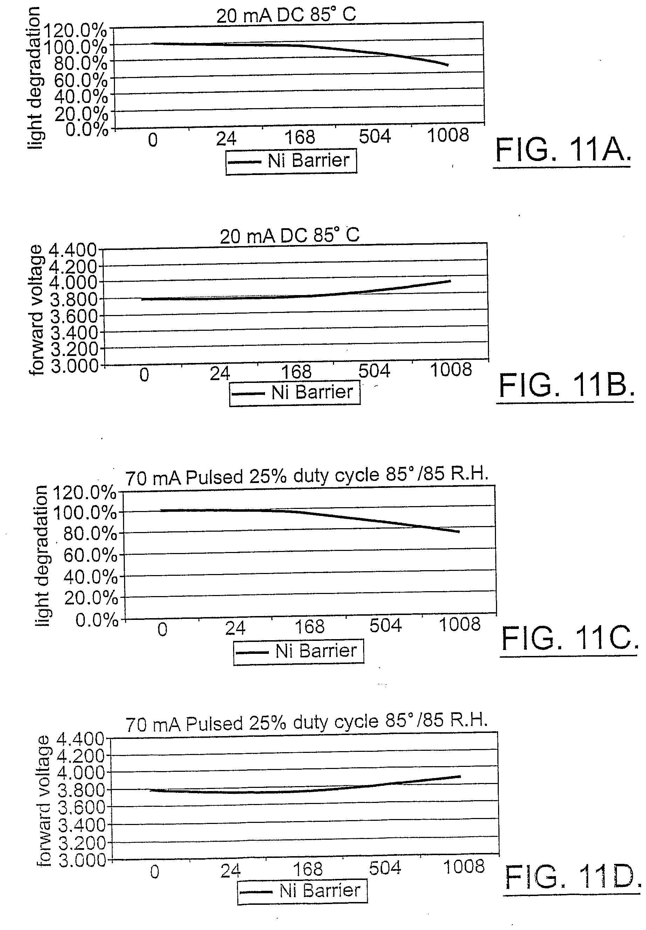

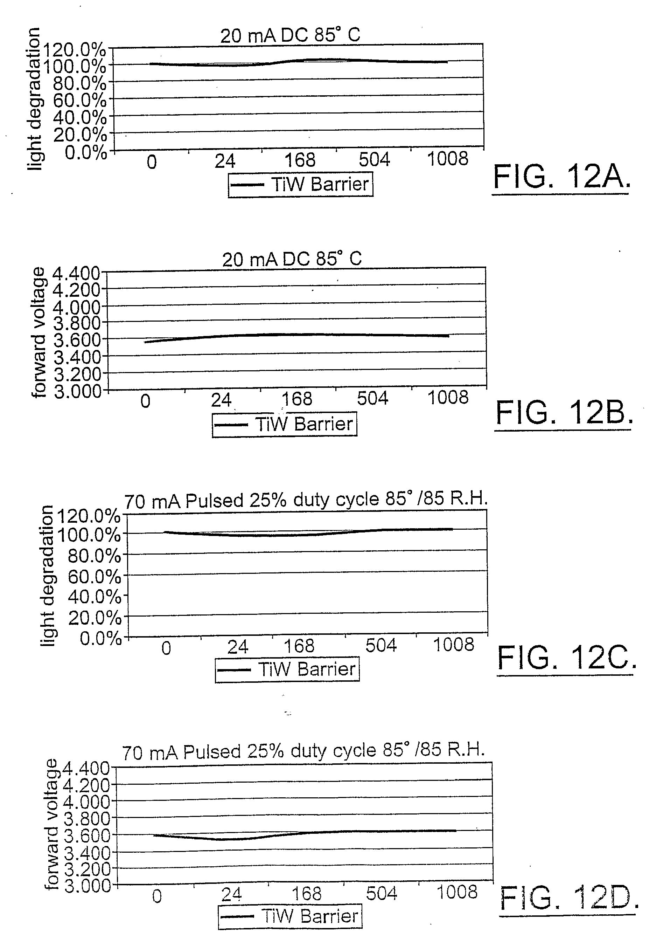

Figures 11A-11D graphically illustrate test results for a 250 nm (2, 500Å) Ni solder barrier while Figures 12A-12D graphically illustrate results for a 500 nm (5,000Å) TiW barrier.

In a first test, the high temperature operating life (HTOL) of a number of LED samples was measured. In this test, twenty LEDs were fabricated with TiW solder barriers **36**, SiN passivation layers **40b** and gold bonding layers **60.** Twenty LEDs also were fabricated with the same structure except that they used an Ni solder barrier. The devices were mounted on silver-plated 5mm radial lead frames via solder bonding. The devices were then operated at a forward current of 20mA while being maintained at a temperature of 85°C. Optical output power and V_{F} were measured after 24, 168, 336, 504, 672, 864 and 1008 hours. As shown in Figures 11A and 12A, the devices with the Ni barrier exhibited larger degradation in light output, compared to the devices with the TiW barrier. Moreover, V_{F} increased more in the Ni barrier devices (Figure 11B) than in the TiW barrier devices (Figure 12B).

In a second test, twenty LEDs were fabricated with TiW solder barriers **36**, SiN passivation layers **40b** and gold bonding layers **60**, and twenty LEDs were fabricated with the same structure except that they used the Ni barrier. The devices were mounted as described above in reference to the HTOL tests and operated at a pulsed forward current of 70 mA (25% duty cycle at 4 kHz) for a period of 504 hours while being maintained at a temperature of 85°C and a relative humidity of 85%. Optical output power and V_{F} were measured after 24, 168, 336, 504, 672, 864 and 1008 hours. As shown in Figures 11C and 12C, larger degradation in light output occurred with the Ni barrier and, as shown in Figures 11D and 12D, a larger increase in V_{F} occurred with the Ni barrier.

### Barrier Layer/Sublayer Structures and Fabrication Methods

It is desirable to limit migration of metal from the reflector layer **34**, also referred to as a mirror **34**, since such metal can short circuit the pn junction of the device if it comes into contact with the mesa **30.** This is particularly true when the mirror **34** comprises silver, which tends to migrate easily at relatively low temperatures. See, for example, the textbook entitled Corrosion and Environmental Degradation, Vol. II, to Schütze, 2000, pp. 451-452. In the presence of surface moisture and an electric field, silver ions can form at positive (anodic) metallizations due to oxidation and/or corrosion. When the silver ions migrate to negative (cathodic) metallizations, they can plate out in the form of a dendrite (i.e., a branching structure). The dendrite may eventually bridge the gap between the anode and cathode of the LED and cause a short circuit.

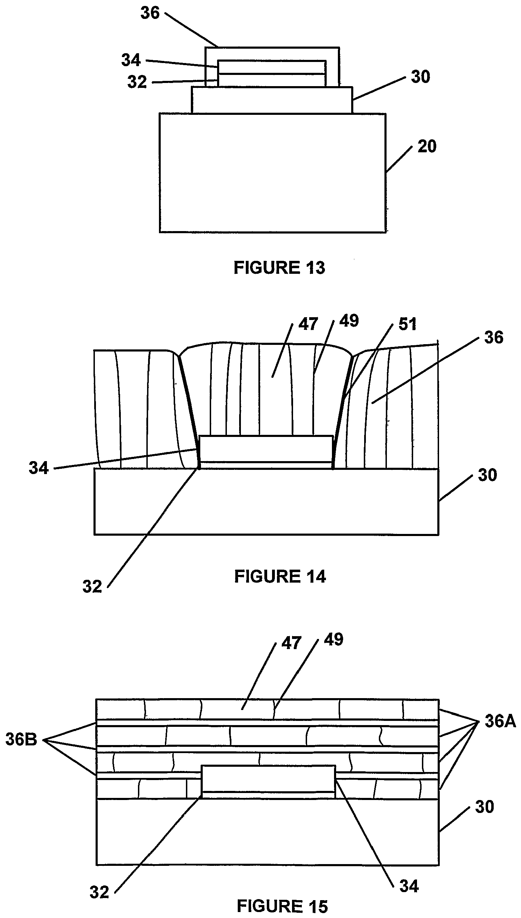

In order to limit migration of the mirror metal **34** to the mesa **30**, according to the present invention, the barrier layer **36** is extended over the sidewalls of the reflector layer **34**, as illustrated in Figure 13. This may be accomplished by performing an additional photolithography step to form the ohmic contact layer **32** and the reflector layer **34** to have a reduced width compared to the width of barrier layer **36**, and/or using other conventional techniques. Thus, when barrier layer **36** is formed, e.g., deposited, it contacts the sidewalls of reflector layer **34** and ohmic contact layer **32** as well as a portion of the surface of mesa **30** surrounding the ohmic contact layer **32** and reflector layer **34.**

If the barrier layer **36** is formed in such a way as to cover the sidewalls of reflector layer **34** as illustrated in Figure 13, it is possible for cracks in the barrier layer to form near the sidewalls of the reflector layer **34.** Such cracks may provide a migration path for silver from the reflector layer **34** to escape and potentially migrate to the mesa **30.** The formation of cracks is illustrated in Figure 14, which shows a mesa **30** on which a thin ohmic contact layer **32** has been formed. A silver reflector layer **34** is formed on the ohmic contact layer **32**, and the entire structure is covered with a layer **36** of a barrier metal such as TiW. As can be seen in Figure 14, when the TiW barrier metal layer **36** is deposited, it forms vertically oriented grains **47** separated by grain boundaries **49.** Misalignment of the grains **47** at the corners of the reflector layer **34** may cause cracks **51** to form, which may provide a migration path for metal from the reflector layer **34** to escape and potentially migrate to the mesa **30.**

In order to reduce or avoid the formation of cracks **51**, a barrier layer **36** according to some embodiments of the present invention may comprise a plurality of alternating sublayers of a barrier metal **36A** such as TiW and a second metal **36B** such as platinum, as illustrated in Figure 15. Suitable metals for second metal **36B** are Pt, Ti, Ni and/or other metals. Metal **36B** should not be susceptible to migration in the LED structure and should have a melting point higher than any of the processing steps subsequently used in the fabrication of the LED (in some embodiments at least about 200°C). In one embodiment, barrier layer 36 comprises alternating sublayers of about 100 nm (1,000Å) of TiW and about 50 nm (500Å) of platinum repeated at least two times with the top and bottom sublayers of the stack both comprising TiW. In other words, the plurality of first and second alternating sublayers define first and second outer sublayers that comprise the first sublayer. In addition, the second (final) outer layer of TiW in the stack may be made approximately 500 nm (5,000Å) thick to act as a solder barrier. In one embodiment, the TiW/Pt layer stacks are repeated six times with the final (terminating) layer of TiW being about 500 nm (5,000Å) thick. Many other thicknesses of the barrier metal **36A** and the second metal **36B** may be used in other embodiments of the invention. In general, barrier metal **36A** should be sufficiently thin to reduce or prevent cracking, but sufficiently thick to provide an effective barrier, while the second metal **36B** should be sufficiently thin so as not to degrade the resistance of the contact, but sufficiently thick to prevent cracks in the barrier metal layer **36A** from propagating across the second barrier layer.

As illustrated in Figure 15, the grain boundaries **49** of successive layers of TiW do not necessarily align vertically, thereby inhibiting the formation of long cracks through the barrier layer **36** that may otherwise provide a migration path for the reflector metal. In that regard, the successive TiW layers may form a pattern that generally resembles a brick wall with stacks of offset grains in each layer.

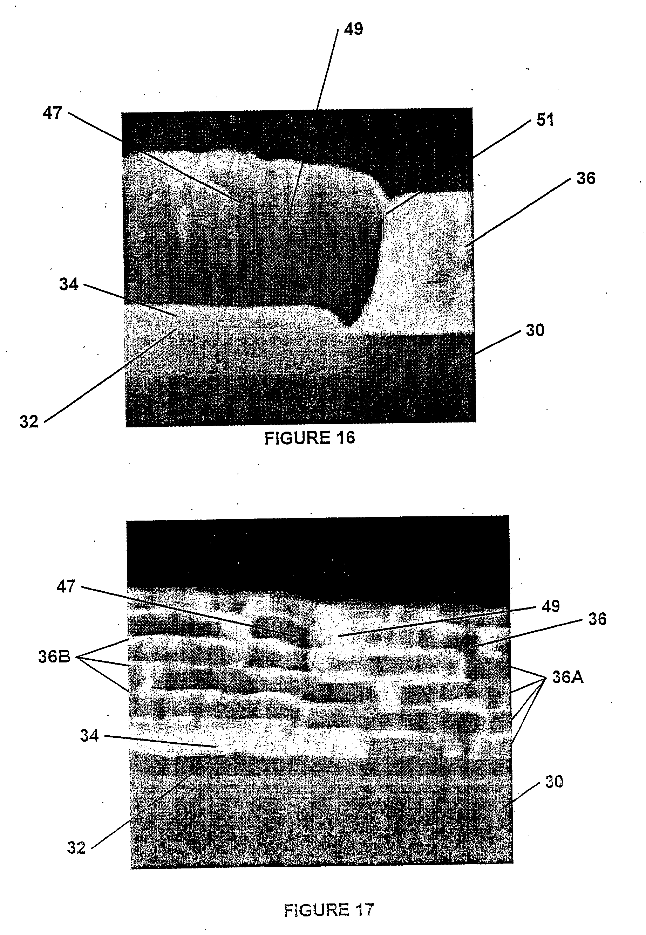

This effect is illustrated in Figures 16 and 17, which are 40,000X SEM images of a metal stack fabricated in accordance with the embodiments illustrated in Figures 14 and 15, respectively. In the structure shown in Figure 16, a TiW barrier layer **36** is deposited as a single layer over a reflector **34** and ohmic contact **32.** Vertical grain boundaries **49** are visible within the barrier layer **36.** In addition, a crack **51** is visible extending from the edge of the reflector layer **34** to the surface of the barrier layer.

In contrast, in the structure shown in Figure 17, the barrier layer **36** comprises a plurality of alternating layers of TiW **36A** and platinum **36B.** The grain boundaries **49** in the alternating layers of TiW **36A** can be clearly seen to form a brick wall pattern over the reflector layer **34** and mesa **30.** In contrast to the structure shown in Figure 16, no cracking is evident in the barrier layer **36.**

In the drawings and specification, there have been disclosed embodiments of the invention and, although specific terms are employed, they are used in a generic and descriptive sense only and not for purposes of limitation, the scope of the invention being defined by the following claims.

## Claims

1. A semiconductor light emitting device for flip-chip mounting comprising: a substrate (20);
an epitaxial region (30) on the substrate that includes therein a light-emitting region;
a multilayer conductive stack (35) comprising a reflector layer (34) including a reflector layer sidewall, on the epitaxial region, and a distinct ohmic contact layer (32) including an ohmic contact layer sidewall, between the reflector layer and the epitaxial region;
a metal conductive barrier layer (36) directly on the reflector layer and extending directly on the reflector layer sidewall and directly on the ohmic contact layer sidewall; and
wherein the reflector layer comprises silver.

2. A light emitting device according to Claim 1 wherein the metal conductive barrier layer (36) further extends onto the epitaxial region (30) outside the multilayer conductive stack (35).

3. A light emitting device according to Claim 1 wherein the metal conductive barrier layer (36) comprises a plurality of first (36A) and second (36B) alternating sublayers.

4. A light emitting device according to Claim 3 wherein the first sublayers (36A) include grain boundaries therein and wherein the second sublayers (36B) are free of grain boundaries.

5. A light emitting device according to Claim 3 wherein the first sublayers (36A) include grain boundaries therein that are arranged such that the grain boundaries define an offset brick wall structure in the first sublayers.

6. A light emitting device according to Claim 3 wherein the first sublayers (36A) comprise titanium tungsten and wherein the second sublayers (36B) comprise platinum, titanium and/or nickel.

7. A light emitting device according to Claim 5 wherein the first sublayers (36A) comprise titanium tungsten and wherein the second (36B) comprise platinum, titanium and/or nickel.

8. A light emitting device according to Claim 3 wherein the second sublayers (36B) are thinner than the first sublayers (36A).

9. A light emitting device according to Claim 7 wherein the second sublayers (36B) are thinner than the first sublayers (36A).

10. A light emitting device according to Claim 3 wherein the first sublayers (36A) comprise titanium tungsten sublayers that are 100 nm thick and wherein the second sublayers (36B) comprise platinum sublayers that are 50 nm thick.

11. A light emitting device according to Claim 1 wherein the substrate (20) comprises silicon carbide and the epitaxial region (30) comprises gallium nitride.

12. A light emitting device according to Claim 1 wherein the ohmic contact layer (32) comprises platinum, palladium, nickel/gold, nickel oxide/gold, nickel oxide/platinum, titanium and/or titanium/gold and wherein the reflector layer (34) comprises aluminium and silver.

13. A method of manufacturing a semiconductor light emitting device for flip-chip mounting that includes a substrate (20), an epitaxial region (30) on the substrate that includes therein a light-emitting region and a multilayer conductive stack comprising a reflector layer (34) including a reflector layer sidewall, on the epitaxial region, and a distinct ohmic contact layer (32) including an ohmic contact layer sidewall, between the reflector layer and the epitaxial region, the method comprising:
forming a metal conductive barrier layer (36) directly on the reflector layer that extends directly on the reflector layer sidewall and directly on the ohmic contact layer sidewall; and
wherein the reflector layer comprises silver.

14. A method according to claim 13 wherein forming the metal conductive barrier layer (36) comprises: forming the metal conductive barrier layer directly on the reflector layer (34) and extending directly on the reflector layer sidewall, directly on the ohmic contact layer (32) sidewall and directly onto the epitaxial region (30) outside the multilayer conductive stack (35).

15. A method according to Claim 13 further comprising: ) forming the metal conductive barrier layer (36) as a plurality of alternating first (36A) and second (36B) sublayers.

16. A method according to Claim 15 wherein the first sublayers (36A) include grain boundaries therein that are arranged such that the grain boundaries define an offset brick wall structure of the first sublayers.

17. A method according to claim 15 wherein the second sublayers (36B) are formed thinner than the first sublayers (36A).

18. A method according to Claim 15 further comprising: terminating the plurality of alternating first (36A) and second (36B) sublayers with a first sublayer to define an outer sublayer.

19. A method according to claim 15 wherein the substrate (20) comprises silicon carbide and the epitaxial region (30) comprises gallium nitride.

## Patentansprüche

1. Lichtemittierende Halbleitervorrichtung für die Flip-Chip-Montage, Folgendes umfassend:
ein Substrat (20); einen Epitaxialbereich (30) auf dem Substrat, der darin einen lichtemittierenden Bereich einschließt;
einen leitfähigen Mehrschichtenstapel (35), der eine Reflektorschicht (34) mit einer Reflektorschicht-Seitenwand auf dem Epitaxialbereich und eine unterschiedliche ohmsche Kontaktschicht (32) mit einer ohmschen Kontaktschicht-Seitenwand zwischen der Reflektorschicht und dem Epitaxialbereich umfasst;
eine leitfähige Metall-Barriereschicht (36) direkt auf der Reflektorschicht und sich direkt auf der Reflektorschicht-Seitenwand und direkt auf der ohmschen Kontaktschicht-Seitenwand erstreckend; und
wobei die Reflektorschicht Silber umfasst.

2. Lichtemittierende Vorrichtung nach Anspruch 1, wobei sich die leitfähige Metall-Barriereschicht (36) weiter auf den Epitaxialbereich (30) außerhalb des leitfähigen Mehrschichtenstapels (35) erstreckt.

3. Lichtemittierende Vorrichtung nach Anspruch 1, wobei die leitfähige Metall-Barriereschicht (36) eine Vielzahl von ersten (36A) und zweiten (36B) alternierenden Teilschichten umfasst.

4. Lichtemittierende Vorrichtung nach Anspruch 3, wobei die ersten Teilschichten (36A) darin Korngrenzen einschließen und wobei die zweiten Teilschichten (36B) frei von Korngrenzen sind.

5. Lichtemittierende Vorrichtung nach Anspruch 3, wobei die ersten Teilschichten (36A) Korngrenzen einschließen, die so angeordnet sind, dass die Korngrenzen eine versetzte Ziegelwandstruktur in den ersten Teilschichten definieren.

6. Lichtemittierende Vorrichtung nach Anspruch 3, wobei die ersten Teilschichten (36A) Titanwolfram umfassen und wobei die zweiten Teilschichten (36B) Platin, Titan und/oder Nickel umfassen.

7. Lichtemittierende Vorrichtung nach Anspruch 5, wobei die ersten Teilschichten (36A) Titanwolfram umfassen und wobei die zweiten (36B) Teilschichten Platin, Titan und/oder Nickel umfassen.

8. Lichtemittierende Vorrichtung nach Anspruch 3, wobei die zweiten Teilschichten (36B) dünner sind als die ersten Teilschichten (36A).

9. Lichtemittierende Vorrichtung nach Anspruch 7, wobei die zweiten Teilschichten (36B) dünner sind als die ersten Teilschichten (36A).

10. Lichtemittierende Vorrichtung nach Anspruch 3, wobei die ersten Teilschichten (36A) Titan-Wolfram-Teilschichten umfassen, die etwa 100 nm dick sind, und wobei die zweiten Teilschichten (36B) Platin-Teilschichten umfassen, die 50 nm dick sind.

11. Lichtemittierende Vorrichtung nach Anspruch 1, wobei das Substrat (20) Siliziumkarbid und der Epitaxialbereich (30) Galliumnitrid umfasst.

12. Lichtemittierende Vorrichtung nach Anspruch 1, wobei die Kontaktschicht (32) Platin, Palladium, Nickel/Gold, Nickeloxid/Gold, Nickeloxid/Platin, Titan und/oder Titan/Gold umfasst und wobei die Reflektorschicht (34) Aluminium und Silber umfasst.

13. Verfahren zur Herstellung einer lichtemittierenden Halbleitervorrichtung für die Flip-Chip-Montage, die Folgendes umfasst: ein Substrat (20), einen Epitaxialbereich (30) auf dem Substrat, der darin einen lichtemittierenden Bereich und einen leitfähigen Mehrschichtenstapel einschließt, der eine Reflektorschicht (34) mit einer Reflektorschicht-Seitenwand auf dem Epitaxialbereich und eine unterschiedliche ohmsche Kontaktschicht (32) mit einer ohmschen Kontaktschicht-Seitenwand zwischen der Reflektorschicht und dem Epitaxialbereich umfasst, wobei das Verfahren Folgendes umfasst: Bilden einer leitfähigen Metall-Barriereschicht (36) direkt auf der Reflektorschicht, die sich direkt auf der Reflektorschicht-Seitenwand und direkt auf der ohmschen Kontaktschicht-Seitenwand erstreckt; und
wobei die Reflektorschicht Silber umfasst.

14. Verfahren nach Anspruch 13, wobei das Formen der leitfähigen Metall-Barriereschicht (36) ferner Folgendes umfasst:
Bilden der leitfähigen Metall-Barriereschicht direkt auf der Reflektorschicht (34) und sich direkt auf der Seitenwand der Reflektorschicht, direkt auf der ohmschen Kontaktschicht (32) Seitenwand und direkt auf dem Epitaxialbereich (30) außerhalb des mehrschichtigen leitfähigen Stapels (35) erstreckend.

15. Verfahren nach Anspruch 13, ferner umfassend:
Bilden der leitfähigen Metall-Barriereschicht (36) als eine Vielzahl von abwechselnden ersten (36A) und zweiten (36B) Teilschichten.

16. Verfahren nach Anspruch 15, wobei die ersten Teilschichten (36A) darin Korngrenzen einschließen, die so angeordnet sind, dass die Korngrenzen eine versetzte Ziegelwandstruktur der ersten Teilschichten definieren.

17. Verfahren nach Anspruch 15, wobei die zweiten Teilschichten (36B) dünner als die ersten Teilschichten (36A) ausgebildet sind.

18. Verfahren nach Anspruch 15, ferner Folgendes umfassend:
Abschließen der Vielzahl von abwechselnden ersten (36A) und zweiten (36B) Teilschichten mit einer ersten Teilschicht, um eine äußere Teilschicht zu definieren.

19. Verfahren nach Anspruch 15, wobei das Substrat (20) Siliziumkarbid und der Epitaxialbereich (30) Galliumnitrid umfasst.

## Revendications

1. Dispositif électroluminescent à semi-conducteur pour connexion par billes comprenant :
un substrat (20) ;
une région épitaxiale (30) sur le substrat qui contient une région électroluminescente ;
un empilement conducteur multicouche (35) comprenant une couche réfléchissante (34) comportant une paroi latérale de couche réfléchissante, sur la région épitaxiale, et une couche de contact ohmique distincte (32) comportant une paroi latérale de couche de contact ohmique, entre la couche réfléchissante et la région épitaxiale ;
une couche barrière conductrice métallique (36) directement sur la couche réfléchissante et s'étendant directement sur la paroi latérale de couche réfléchissante et directement sur la paroi latérale de couche de contact ohmique ; et
dans lequel la couche réfléchissante comprend de l'argent.

2. Dispositif électroluminescent selon la revendication 1, dans lequel la couche barrière conductrice métallique (36) s'étend en outre sur la région épitaxiale (30) à l'extérieur de l'empilement conducteur multicouche (35).

3. Dispositif électroluminescent selon la revendication 1, dans lequel la couche barrière conductrice métallique (36) comprend une pluralité de premières (36A) et deuxièmes (36B) sous-couches alternées.

4. Dispositif électroluminescent selon la revendication 3, dans lequel les premières sous-couches (36A) contiennent des joints de grains et dans lequel les deuxièmes sous-couches (36B) sont exemptes de joints de grains.

5. Dispositif électroluminescent selon la revendication 3, dans lequel les premières sous-couches (36A) contiennent des joints de grains qui sont agencés de manière à ce que les joints de grains définissent une structure de mur en briques décalées dans les premières sous-couches.

6. Dispositif électroluminescent selon la revendication 3, dans lequel les premières sous-couches (36A) comprennent du titane-tungstène et dans lequel les deuxièmes sous-couches (36B) comprennent du platine, du titane et/ou du nickel.

7. Dispositif électroluminescent selon la revendication 5, dans lequel les premières sous-couches (36A) comprennent du titane-tungstène et dans lequel les deuxièmes sous-couches (36B) comprennent du platine, du titane et/ou du nickel.

8. Dispositif électroluminescent selon la revendication 3, dans lequel les deuxièmes sous-couches (36B) sont plus minces que les premières sous-couches (36A).

9. Dispositif électroluminescent selon la revendication 7, dans lequel les deuxièmes sous-couches (36B) sont plus minces que les premières sous-couches (36A).

10. Dispositif électroluminescent selon la revendication 3, dans lequel les premières sous-couches (36A) comprennent des sous-couches de titane-tungstène qui sont de 100 nm d'épaisseur et dans lequel les deuxièmes sous-couches (36B) comprennent des sous-couches de platine qui sont de 50 nm d'épaisseur.

11. Dispositif électroluminescent selon la revendication 1, dans lequel le substrat (20) comprend du carbure de silicium et la région épitaxiale (30) comprend du nitrure de gallium.

12. Dispositif électroluminescent selon la revendication 1, dans lequel la couche de contact ohmique (32) comprend du platine, du palladium, du nickel/or, de l'oxyde de nickel/or, de l'oxyde de nickel/platine, du titane et/ou du titane/or et dans lequel la couche réfléchissante (34) comprend de l'aluminium et de l'argent.

13. Procédé de fabrication d'un dispositif électroluminescent à semi-conducteur pour connexion par billes qui comporte un substrat (20), une région épitaxiale (30) sur le substrat qui contient une région électroluminescente et un empilement conducteur multicouche comprenant une couche réfléchissante (34) comportant une paroi latérale de couche réfléchissante, sur la région épitaxiale, et une couche de contact ohmique distincte (32) comportant une paroi latérale de couche de contact ohmique, entre la couche réfléchissante et la région épitaxiale, le procédé comprenant l'étape consistant :
à former une couche barrière conductrice métallique (36) directement sur la couche réfléchissante qui s'étend directement sur la paroi latérale de couche réfléchissante et directement sur la paroi latérale de couche de contact ohmique ; et
dans lequel la couche réfléchissante comprend de l'argent.

14. Procédé selon la revendication 13, dans lequel la formation de la couche barrière conductrice métallique (36) comprend l'étape consistant :
à former la couche barrière conductrice métallique directement sur la couche réfléchissante (34) et s'étendant directement sur la paroi latérale de couche réfléchissante, directement sur la paroi latérale de couche de contact ohmique (32) et directement sur la région épitaxiale (30) à l'extérieur de l'empilement conducteur multicouche (35).

15. Procédé selon la revendication 13, comprenant en outre l'étape consistant :
à former la couche barrière conductrice métallique (36) sous forme d'une pluralité de premières (36A) et deuxièmes (36B) sous-couches alternées.

16. Procédé selon la revendication 15, dans lequel les premières sous-couches (36A) contiennent des joints de grains qui sont agencés de manière à ce que les joints de grains définissent une structure de mur en briques décalées des premières sous-couches.

17. Procédé selon la revendication 15, dans lequel les deuxièmes sous-couches (36B) sont formées de manière à être plus minces que les premières sous-couches (36A).

18. Procédé selon la revendication 15, comprenant en outre l'étape consistant :
à terminer la pluralité de premières (36A) et deuxièmes (36B) sous-couches alternées par une première sous-couche afin de définir une sous-couche externe.

19. Procédé selon la revendication 15, dans lequel le substrat (20) comprend du carbure de silicium et la région épitaxiale (30) comprend du nitrure de gallium.
